# EUROPÄISCHE PATENTSCHRIFT

(11) **EP 3 296 054 B1**
(45) Veröffentlichungstag und Bekanntmachung des Hinweises auf die Patenterteilung: **16.12.2020**
(21) Anmeldenummer: 16189398.7
(22) Anmeldetag: 19.09.2016
(51) Int. Cl.: B23K 35/22, B23K 26/60, B23K 26/36, B23K 26/40

(54) **VERFAHREN ZUR HERSTELLUNG EINES MIKROBEARBEITETEN WERKSTÜCKS MITTELS LASERABTRAG**
METHOD FOR PRODUCING A MICRO-MACHINED WORKPIECE BY MEANS OF LASER ABLATION
PROCÉDÉ DE FABRICATION D'UNE PIÈCE MICRO-USINÉE PAR ÉROSION AU LASER

(43) Veröffentlichungstag der Anmeldung: 21.03.2018
(73) Patentinhaber: Fraunhofer-Gesellschaft zur Förderung der angewandten Forschung e.V., 80686 München (DE)
(72) Erfinder: HÖCHE, Prof. Dr. Thomas, 06120 Halle (DE); KRAUSE, Dr. Michael, 06108 Halle (DE)
(74) Vertreter: Patentanwälte Ruff, Wilhelm, Beier, Dauster & Partner mbB

(56) Entgegenhaltungen:
- EP-A1- 1 811 055
- DE-C1- 19 536 312
- US-A1- 2010 078 416

## Beschreibung

### ANWENDUNGSGEBIET UND STAND DER TECHNIK

Die Erfindung betrifft ein Verfahren zur Herstellung eines mikrobearbeiteten Werkstücks mittels Laserabtrag, worin eine Schutzschicht auf einen Bearbeitungsbereich der Oberfläche des Werkstücks aufgebracht wird und die Oberfläche in einem Bearbeitungsbereich durch die Schutzschicht hindurch mittels eines Laserstrahls bearbeitet wird.

Typische Bearbeitungsaufgaben der Lasermikrobearbeitung betreffen das Bohren von feinsten Löchern, dass Schneiden von Kerben und das Abtragen von Flanken an Werkstücken. Bedingt durch das häufig Gauß-förmige Strahlprofil eines Laserstrahls weisen Eintrittskanten an Werkstückoberflächen oftmals Aufwerfungen ("burr") auf oder neigen in Oberflächennähe zur Verrundung und sind gesäumt von an der Oberfläche anhaftenden Ablagerungen. Die Eintrittskanten sind zudem häufig stärkeren Temperatureinflüssen ausgesetzt. Durch die häufig nicht vollständig entfernbaren und ggf. aufgrund des hochangeregten Ablationsplasmas fest an Oberflächen anhaftenden Abtragsprodukte ("debris") sind die Eintrittskanten bedingt durch die optische Nahfeld-Wechselwirkung der Laserstrahlung mit lokal anhaftenden, nanoskaligen Abtragsprodukten oftmals nicht ideal glatt, sondern weisen "curtaining" auf.

Die GB 2 349 106 A beschreibt, dass die Ablagerung von Abtragsprodukten ("sputter") an der Werkstückoberfläche während des Laser-Perkussionsbohrens vermieden werden kann, indem auf die Oberfläche des Werkstücks eine Beschichtung aufgebracht wird, die Partikel enthält, welche in einer Polymermatrix verteilt sind. Die Polymermatrix kann z.B. eine Silikon-Dichtmasse sein, die Partikel bestehen aus einem Keramikmaterial oder einen hochschmelzenden Material. Die Beschichtungsmasse, in der die Polymermatrix und die darin verteilten Partikel (im Beispiel Siliziumkarbid) etwa zu gleichen Gewichtsanteilen vorhanden sein sollten, wird nach dem Verteilen auf die Oberfläche bei Raumtemperatur oder unter Aufheizen ausgehärtet. Die gut auf der Oberfläche haftende polymere Beschichtung soll unter anderem die laterale Wärmeausbreitung quer zum Laserstrahl begrenzen, so dass das Loch in der Beschichtung nicht wesentlich größer wird als die Bohrung im Werkstück. Nach Abschluss der Laserbearbeitung kann die Beschichtung gemeinsam mit den Abtragsprodukten von der Oberfläche abgelöst werden.

Die JP H08187588 A beschreibt die Verwendung eines Schutzfilms aus Polyimid auf der Oberfläche eines mittels Laserbearbeitung bearbeiteten Werkstücks. Die Abtragsprodukte lagern sich auf dem Schutzfilm ab und können gemeinsam mit diesem nach der Laserbearbeitung entfernt werden.

Die DE 10 2006 023 940 A1 beschreibt ein Verfahren zur Nanostrukturierung eines Substrats durch direkte Laserablation. Die zu bestrahlende Oberfläche ist mit einer flüssigen, gelartigen oder vernetzten Opferschicht beschichtet, die für das zur Musterbildung verwendete Laserlicht transparent ist.

Die DE 101 40 533 B4 beschreibt ein Verfahren zur Mikrobearbeitung eines Werkstücks mittels ultrakurzgepulster Laserstrahlung. Dabei wird eine z.B. aus Kupfer bestehende monolithische Opferschicht fest auf eine Oberfläche des Werkstücks aufgelegt. Anschließend werden ultrakurze Laserpulse erzeugt, die die Opferschicht durchdringen und Material des Werkstücks abtragen. Nach ausreichendem Abtrag von Material des Werkstücks wird die Opferschicht abgenommen. Dadurch, dass die Opferschicht nicht chemisch fest mit dem zu bearbeitenden Werkstück verbunden wird, lässt sich die Opferschicht nach der Laserbearbeitung leicht entfernen. Zusammen mit der Opferschicht werden auch die von dem Werkstück abgetragenen Partikel, die sich auf der freien Oberfläche der Opferschicht abgelagert haben, entfernt. Das durch die Laserstrahlung hervorgerufene, strahleintrittsseitige Kantenprofil mit einer Kantenverrundung ist in der Opferschicht ausgebildet und wird mit dieser entfernt. Dadurch wird eine scharfkantige Kontur am Übergang zwischen der Oberfläche des Werkstücks und der durch die Laserstrahlung hervorgerufenen Vertiefung oder Bohrung erzeugt.

Die EP 1 811 055 A1 beschreibt ein Verfahren zur Laserbearbeitung insbesondere von Turbinenschaufeln, bei dem neben einem metallischen Haftgrund eine Schutzschicht keramischer Art bestehend beispielsweise aus voll- oder teilstabilisiertem Zirkoniumoxid oder aus Keramiken, die nicht, teilweise oder vollständig mittels Yttriumoxid und/oder Calciumoxid und/oder Magnesiumoxid stabilisiert sind, aufgebracht wird. Diese dient zum Schutz vor Laserzunder und metallischen Spritzern.

### AUFGABE UND LÖSUNG

Es ist eine Aufgabe der Erfindung, ein Verfahren der eingangs erwähnten Art bereitzustellen, das es ermöglicht, die Qualität des durch Laserabtrag mikrobearbeiteten Werkstücks im bearbeiteten Bereich gegenüber herkömmlichen Verfahren zu verbessern.

Zur Lösung dieser Aufgabe stellt die Erfindung ein Verfahren mit den Merkmalen von Anspruch 1 bereit. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Bei dem Verfahren wird die Schutzschicht unter Verwendung eines Schichtfluids erzeugt, das eine teilweise oder vollständig flüchtige Trägerflüssigkeit aufweist, in der metallische Partikel verteilt sind. Das Schichtfluid wird auf die Oberfläche des Werkstücks so aufgebracht, dass wenigstens der zur Laserbearbeitung vorgesehene Bearbeitungsbereich mit einer Schicht des Schichtfluids bedeckt ist. Das Schichtfluid kann dabei direkt bzw. unmittelbar auf die Oberfläche aufgebracht werden oder mittelbar unter Zwischenschaltung einer Zwischenschicht.

Danach wird die aufgebrachte Schicht aus Schichtfluid getrocknet, um den Anteil an Trägerflüssigkeit derart zu reduzieren, dass sich eine Schutzschicht bildet, die im Wesentlichen aus den Partikeln des aufgebrachten Schichtfluids besteht oder aus diesen Partikeln und einem gegenüber dem Schichtfluid reduzierten Anteil bzw. einem Rest der Trägerflüssigkeit. Der Bearbeitungsbereich wird dann mittels (mindestens) eines Laserstrahls bearbeitet, der durch die Schutzschicht hindurch auf das Werkstück eingestrahlt wird.

Das Schichtfluid kann als fließfähige Dispersion mit flüssigem Dispersionsmedium (der Trägerflüssigkeit) und festen dispergierten Partikeln beschrieben werden. Das Schichtfluid ist eine fließfähige Substanz, deren Viskosität angepasst an den Anwendungsfall unterschiedlich gewählt sein kann. Dabei sind dünnflüssige Schichtfluide nach Art einer Tinte mit einer Viskosität ähnlich derjenigen von Wasser oder Alkohol genauso möglich wie zähflüssigere Schichtfluide, z.B. mit einer Viskosität eines Lacks oder von Honig oder einer Creme oder Paste. Die Trägerflüssigkeit dient bei dem Verfahren im Wesentlichen als Hilfsmittel bei der formschlüssigen Applikation bzw. topographiekonformen Aufbringung des Schichtfluids auf die Oberfläche, um eine gewünschte Verteilung der Partikel auf der Oberfläche zu ermöglichen. Die Trägerflüssigkeit sollte mehr oder weniger leicht flüchtig sein, um die spätere Trocknung (Durchtrocknung oder Teil-Trocknung) der aufgebrachten Schicht zu erleichtern. Die Trägerflüssigkeit kann so gewählt sein, dass flüchtige Bestandteile bereits bei Raumtemperatur oder leicht erhöhten Temperaturen allmählich verdampfen kann, so dass sich während der Trocknungsphase der Anteil der Trägerflüssigkeit in der Schicht reduziert bzw. der Partikelanteil in der Schicht zunimmt. Um ein Verdampfen der Trägerflüssigkeit nach dem Aufbringen der Schicht zu erleichtern, sollte die Trägerflüssigkeit möglichst wenig oder nicht polymerisierend bzw. kaum oder nicht aushärtbar sein. Dadurch kann auch ein eventuell gewünschtes späteres Ablösen der Schicht nach Abschluss der Laserbearbeitung begünstigt werden.

Die Trägerflüssigkeit kann eine einkomponentige Trägerflüssigkeit sein, also eine Trägerflüssigkeit, die im Wesentlichen aus einer einzigen flüssigen Komponente besteht, ggf. mit Verunreinigungen durch andere Substanzen. Es ist auch möglich, dass die Trägerflüssigkeit aus zwei oder mehr unterschiedlichen Komponenten besteht, also eine mehrkomponentige Trägerflüssigkeit ist. Eine der Komponenten kann z.B. eine relativ leicht flüchtige Komponente sein, z.B. auf Basis von Alkohol oder einem Keton, wie z.B. Aceton, oder einem Acetat. Eine andere Komponente kann schwerer flüchtig oder nicht flüchtig sein und ggf. mindestens teilweise in der Schutzschicht verbleiben und dort den Zusammenhalt der Partikel fördern.

Die Schicht kann ggf. ohne besondere trocknungsfördernde Maßnahmen selbsttätig trocknen. Es ist auch möglich, den Trocknungsschritt aktiv zu beschleunigen, z.B. durch Aufheizen und/oder durch Anblasen etc. Dadurch kann das Verdampfen der flüchtigen Anteile der Trägerflüssigkeit beschleunigt werden.

Während des Trocknungsschritts wird die aufgebrachte Schicht, die zunächst noch im Wesentlichen die Viskosität des Schichtfluides haben kann, getrocknet, um den Anteil von (flüchtiger) Trägerflüssigkeit zu reduzieren. Durch den Trocknungsschritt kann eine teilgetrocknete oder eine praktisch vollständig durchgetrocknete Schutzschicht erzeugt werden. Eine teilgetrocknete Schutzschicht kann noch feucht sein und enthält noch wenigstens bereichsweise Anteile an Trägerflüssigkeit, ist jedoch hinsichtlich ihrer Fließfähigkeit schon so stark reduziert, dass sie gut auf der Oberfläche haftet. Bei längerer Trocknung kann die Schutzschicht vollständig durchtrocknen, so dass praktisch keine flüchtigen Bestandteile der Trägerflüssigkeit mehr in der Schutzsicht vorhanden ist.

Durch den Trocknungsschritt soll u.a. ermöglicht werden, dass das Werkstück mitsamt der teilgetrockneten oder vollständig getrockneten Schutzschicht bei Bedarf aus der Horizontalen gekippt werden kann, ohne das die Schutzschicht sich von der Oberfläche löst. Die Schutzschicht sollte in der Regel auch so weit getrocknet sein, dass die Position des Laserabtrags während der Laserbearbeitung in einem starken Luftstrom gezielt angeblasen werden kann, ohne dass die Schutzschicht ihre Wirksamkeit verliert.

Für die Material abtragende Laserablation wird dann der Bearbeitungsbereich mittels eines Laserstrahls bearbeitet, der durch die teilgetrocknete oder vollständig getrocknete Schutzschicht hindurch auf das Werkstück eingestrahlt wird. Insbesondere kann es sich um einen gepulsten Laserstrahl handeln, der z.B. mit einem Ultrakurzpulslaser erzeugt wird.

Mit Hilfe des Verfahrens können sowohl glatte Oberflächen als auch nicht exakt glatte Oberflächen, die beispielsweise leicht herausstehenden Leiterbahnen aufweisen können, konform und formschlüssig beschichtet werden.

Die Zusammensetzung bzw. Formulierung des Schichtfluids kann an die Bedingungen des spezifischen Anwendungsfalles in weiten Grenzen angepasst werden. Bei vielen Ausführungsformen wird ein Schichtfluid verwendet, bei dem die in der Trägerflüssigkeit verteilten Partikel überwiegend eine Partikelgröße von maximal 10 µm aufweisen. "Überwiegend" bedeutet hier insbesondere, dass mindestens 70% oder mindestens 80% der Partikel diese relativ geringe Größe aufweisen sollten. Insbesondere kann die mittlere Partikelgröße im einstelligen Mikrometerbereich oder darunter liegen. Einige oder alle Partikel können eine mittlere Partikelgröße von weniger als 1 µm aufweisen. Es können schuppenförmige bzw. plättchenartige Partikel ("flakes") vorliegen, also flache Partikel, deren größter Durchmesser deutlich größer ist als ihre Höhe. Der Durchmesser kann z.B. bei höchstens 10 µm liegen, während die Höhe häufig deutlich unterhalb 1 µm bzw. im Bereich einiger hundert Nanometer liegen kann. In der Regel ist eine gewisse Verteilung hinsichtlich Form und/oder Größe der Partikel vorgesehen und auch nützlich, um in der teilgetrockneten oder vollständig durchgetrockneten Schutzschicht eine relativ dichte mikroporöse oder nanoporöse Struktur zu erzielen.

Die Zusammensetzung des Schichtfluids kann so gewählt sein, dass der Füllgrad der Partikel in der fertigen (teilgetrockneten oder vollständig durchgetrockneten) Schutzschicht bei deutlich über 50% des Schutzschichtvolumens liegt. Als "Füllgrad" wird hier das Verhältnis zwischen dem Gesamt-Volumen der Partikel in einem Einheitsvolumen der Schutzschicht und dem betrachteten Einheitsvolumen bezeichnet. Der Füllgrad kann z.B. bei 60% oder mehr liegen oder auch bei mindestens 70%. Bei manchen Silbertinten sind die Silberteilchen auf kolloidaler Längenskala, z.B. im Größenbereich von ca. 2 nm bis ca. 20 nm. Bei derartigen kolloidalen Schichtfluiden sind auch höhere Füllgrade, z.B. bis in den Bereich von 90% erreichbar. In der Regel verbleibt in der Schutzschicht eine Rest-Porosität. Außerdem können Reste der Trägerflüssigkeit in der Schutzschicht vorliegen, so dass der Füllgrad der Partikel meist bei weniger als 90% liegt.

Auch die Materialien der Partikel können an den Anwendungsfall angepasst werden. In vielen Anwendungsfällen ist es vorteilhaft, wenn ein Schichtfluid verwendet wird, das überwiegend (z.B. zu mindestens 80% oder zu mindestens 90%) oder ausschließlich die metallischen Partikel enthält. Durch die Verwendung metallischer Partikel im Schichtfluid wird eine Schutzschicht mit hoher thermischer Leitfähigkeit geschaffen, was sich günstig auf das Wärmemanagement bzw. die Abfuhr von Wärme aus dem unmittelbar vom Laserstrahl getroffenen Bereich auswirkt. Zudem haben Metalle typischerweise eine relativ hohe Abtragschwelle, so dass die mit metallischen Partikeln ausgestattete Schutzschicht auch unter längerer Laserbestrahlung lange wirksam bleibt, z.B. gegen Kantenverrundung. Metallische Partikel können unbeschichtet sein oder eine Beschichtung tragen, z.B. eine dünne oxidische oder keramische Beschichtung. Es können metallische Partikel (beschichtet oder unbeschichtet) und keramische Partikel in der Trägerflüssigkeit bzw. in der daraus resultierenden Schutzschicht gemischt vorliegen. Da Keramiken häufig noch höhere Abtragschwellen haben als Metalle, kann durch Verwendung keramischer Partikel (alternativ oder zusätzlich zu metallischen Partikeln) die Beständigkeit der Schutzschicht unter Laserbestrahlung bei Bedarf noch gesteigert werden.

Beispielsweise können viele kommerziell verfügbare Metalltinten oder Metalllacke mit beschichteten oder unbeschichteten Partikeln aus Silber, Gold, Aluminium, Kupfer, Nickel und/oder einem anderen Metall sowie ggf. (alternativ zusätzlich) mit keramischen Partikeln als Schichtfluid im Rahmen des Verfahrens genutzt werden.

Bei manchen Ausführungsformen wird ein Leitlack als Schichtfluid verwendet. Der Begriff "Leitlack" bezeichnet einen elektrisch leitfähigen Lack, der konventionell vor allem in der Elektronik zum Einsatz kommt. Die elektrische Leitfähigkeit wird durch einen sehr hohen Anteil (bis zu 80 % und mehr) leitfähiger Füllmaterialien in der Lackmatrix erzeugt. Die einzelnen Partikel stehen in Kontakt zueinander und ermöglichen so den Stromfluss. Leitlacke gibt es z.B. auf Basis von Silber- (Silberleitlack oder Leitsilber), Kupfer- (Kupferleitlack) und Graphitpartikeln (Graphitleitlack). Die Binderkomponente kann ein einkomponentiger lösemittelhaltiger Lack oder ein Kunstharz (ein- oder zweikomponentig) sein.

Ein Teilaspekt der Erfindung betrifft somit eine neue vorteilhafte Verwendung für konventionell andere Zwecke genutzte, metallische Partikel aufweisenden Leitlacke, insbesondere Leitsilber, nämlich die Verwendung als Schichtfluid zur Erzeugung einer Schutzschicht bei dem in dieser Anmeldung beschriebenen Verfahren.

Mit Hilfe des Verfahrens können hochwirksame, multifunktionelle Schutzschichten erzeugt werden. Dabei können relativ geringe effektive Schutzschichtdicken ausreichen, um die eingangs angesprochenen Probleme zu vermindern oder zu vermeiden. Der Begriff "effektive Schutzschichtdicke" bezeichnet hierbei diejenige Schichtdicke der Schutzschicht, die während der Laserbearbeitung vorliegt, also dann, wenn die Schicht wenigstens teilweise getrocknet ist und relativ sicher an der Oberfläche haftet.

Unter der Annahme eines Gauß-förmigen Strahlprofils sollte die effektive Schichtdicke so groß sein, dass im Werkstück eine möglichst glatte Flanke ohne Verrundung entsteht. Ein wichtiges Kriterium ist die intendierte Wirkung auf die Schärfung des wirksamen Laserstrahls. Dabei sollte die Schutzschicht weiterhin so dünn sein, dass der Laserstrahl in endlicher Zeit auf die Werkstückoberfläche durchdringt. Bei vielen Ausführungsbeispielen wird die Schutzschicht mit einer effektiven Schutzschichtdicke von weniger als 50 µm erzeugt. Nach den bisherigen Erkenntnissen erscheinen effektive Schutzschichtdicken aus dem Bereich von 5 µm bis 50 µm in vielen praktischen Fällen vorteilhaft. Bei deutlich kleineren effektiven Schutzschichtdicken kann es insbesondere sein, dass eine Kantenverrundung bis in den Bereich des bearbeiteten Werkstücks reichen kann. Deutlich größere Schichtdicken scheinen häufig nicht erforderlich und würden hauptsächlich zu größerem Materialverbrauch des Schichtfluids führen, ohne entsprechend Zusatznutzen.

Es kann aber durchaus sein, dass auch sehr viel dickere Schichten erforderlich sind, z.B. für einen 400 W Laser mit einem sehr ungünstigen Strahlprofil M²>2, d.h. Donut-förmigem Strahlquerschnitt. Eine optimale effektive Schichtdicke kann also auch bei mehr als 50 µm liegen, z.B. im Bereich von 50 µm bis 200 µm oder mehr, z.B. bis 1 mm oder 2 mm.

Es ist grundsätzlich möglich, dass die Schutzschicht nach Abschluss der Laserbearbeitung auf der Oberfläche verbleibt. Dies kann z.B. bei der Laser-basierten Probenpräparation für die Mikrostrukturdiagnostik der Fall sein. Die Schutzschicht sollte dann allerdings nach Möglichkeit relativ dünn sein, z.B. mit einer effektiven Schichtdicke im Bereich von 5 µm bis 10 µm. In vielen Fällen wird jedoch die Schutzschicht nach Abschluss der Laserbearbeitung von der Oberfläche entfernt. Gemeinsam mit der Schutzschicht können dadurch auch die auf der Schutzschicht verbliebenen Ablagerungen ("debis") von der Werkstückoberfläche entfernt werden.

Ein großer Vorteil bevorzugter Varianten des Verfahrens liegt darin, dass die Schutzschicht bei Bedarf ohne großen Aufwand und werkstückschonend rückstandsfrei vom Werkstück abgelöst bzw. entfernt werden kann. Vorzugsweise wird dabei zum Entfernen der Schutzschicht ein Lösungsmittel verwendet, welches in der Schutzschicht zurückgebliebene Bestandteile der ggf. mehrkomponentigen Trägerflüssigkeit löst. Diese nasschemische Beseitigung der Schutzschicht kann in der Regel bei Umgebungstemperatur stattfinden und schont das Werkstück, da keine mechanischen Kräfte auf die Schutzschicht wirken müssen.

Alternativ zu nasschemischen Lösungsmitteln kann auch ein lokalisiert applizierter CO₂-Strahl (gelegentlich auch "snow jet" genannt) zum Ablösen der Schutzschicht genutzt werden. Hierbei wird (flüssiges) CO₂ beim Austritt aus einer Düse entspannt, mittels Druckluft auf Überschallgeschwindigkeit beschleunigt und auf die Probe geleitet. Beim Auftreffen auf die Schutzschicht kühlt sich diese schnell ab und versprödet infolgedessen. Da der CO₂-Schnee beim Auftreffen auf die Oberfläche mit einer Volumenzunahme (600-fach) abdampft, werden Partikel-Belegungen in der Regel nahezu rückstandsfrei von der Oberfläche gesprengt. Dieser Umstand kann zusätzlich dadurch begünstigt werden, dass CO₂ ein starkes Lösungsmittel für organische Verbindungen ist, die in einer Schichtformulierung als Binder oder Stabilisatoren enthaltenen sein können.

Obwohl die Schutzschicht aufgrund des Applikationsprozesses (Aufbringen eines Schichtfluids, teilweises oder vollständiges Trocknen) in der Regel flächig und ohne Spalten formschlüssig an der Oberfläche haftet, besteht in der Regel keine allzu starke Bindung der Schutzschicht zur Oberfläche. Dadurch ist es in vielen Fällen möglich, eine in sich stark gebundene Schutzschicht als Ganzes leicht von der Oberfläche zu lösen. Die Schutzschicht kann auch so aufgebaut sein, dass die einzelnen Partikel (beispielsweise "flakes") durch nicht-flüchtige Rückstände der Trägerflüssigkeit vor direktem Kontakt untereinander bewahrt werden. Dadurch kann erreicht werden, dass auch die Bindung zwischen den Partikeln nicht beliebig hoch werden muss, um eine zuverlässige Schutzschicht zu erreichen. Eine derartige Schutzschicht lässt sich nasschemisch oder mit einer anderen Lösungsmittelapplikation leicht lösen, indem z.B. organische Bestandteile zwischen den Partikeln herausgelöst werden.

Wie eingangs erwähnt, kann die Schutzschicht sowohl in nur teilweise getrockneter Form (ggf. feucht) als auch in vollständig durchgetrockneter Form vorliegen. Im Hinblick auf eine nachfolgende leichte Ablösbarkeit der Schutzschicht können Verfahrensvarianten vorteilhaft sein, bei denen die Laserbearbeitung während einer Trocknungsphase der aufgebrachten Schicht innerhalb eines Zeitfensters durchgeführt wird, in welchem die Schutzschicht noch einen Anteil an Trägerflüssigkeit enthält. Eine derartig noch nicht vollständig durchgetrocknete, feuchte Schicht kann in der Regel relativ leicht z.B. nasschemisch völlig rückstandsfrei von der Werkstückoberfläche entfernt werden.

Es ist möglich, das Schichtfluid vollflächig auf die Werkstückoberfläche aufzubringen und damit auch solche Bereiche der Werkstückoberfläche mit einer Schutzschicht zu schützen, die später nicht mittels Laserstrahl bearbeitet werden sollen. Eine vollflächige und strukturierte Aufbringung kann beispielsweise mittels Siebdruck, Rakeln, Hochdruck-Verdüsung, spin-coating, dip-coating, Tampondruck oder dergleichen erfolgen.

Das Verfahren bietet jedoch auch die Möglichkeit, dass beim Aufbringen des Schichtfluids das Schichtfluid lokal begrenzt nur in einem den Bearbeitungsbereich enthaltenen Beschichtungsbereich auf die Oberfläche aufgebracht wird. Der Beschichtungsbereich kann z.B. rund oder oval oder annähernd polygonal begrenzt oder streifenförmig gestaltet sein. Er kann symmetrisch oder unsymmetrisch um die Bearbeitungsstelle verteilt liegen. Die lokale Aufbringung bedeutet, dass außerhalb eines Beschichtungsbereiches die Oberfläche unbeschichtet bzw. frei von Schutzschicht bleibt. Hinsichtlich der lateralen Ausdehnung des Beschichtungsbereichs kann beachtet werden, dass es ausreichen kann, nur den maximalen Flugradius der Abtragsprodukte (debris-Partikel) zuverlässig abzudecken, um die Oberfläche rein zu halten. Nach den Erfahrungen der Erfinder spielen sich diejenigen Effekte, die zur Kantenverrundung und im Hinblick auf Wärmemangagement von Bedeutung sind, lateral innerhalb weniger Mikrometer um die jeweilige Bearbeitungsstelle ab, während Abtragspartikel unter ungünstigen Umständen auch einige hundert Mikrometer oder einige Millimeter weit fliegen können. Im Hinblick auf diese Verhältnisse können Beschichtungsbereiche z.B. so groß sein, dass sie einen Bereich von maximal 2 mm bis 5 mm um die Bearbeitungsstruktur herum abdecken, ggf. auch mehr. Wird das Schichtfluid bzw. die Schutzschicht nur lokal begrenzt aufgebracht, so kann ggf. in erheblichem Umfang Schichtfluid eingespart werden, was sowohl im Hinblick auf die Kosten des Verfahrens als auch aus Geschwindigkeits- und Umweltgesichtspunkten vorteilhaft ist.

Soll die Schutzschicht definiert lokal aufgebracht werden, so erscheinen vor allem volumetrische Verfahren zum Aufbringen eines Schichtfluids geeignet, z.B. solche unter Verwendung von Dosierventilen (beispielsweise Jet-Valve, Kolben- und Spindelventile) oder unter Verwendung von Sprühventilen. Gegebenenfalls können mittels continous-inkjet (drop-ondemand) einzelne Tropfen des Schichtfluids zielgerichtet mittels elektrostatischer Ablenker auf den Zielbereich (Beschichtungsbereich) appliziert werden. Alternativ kann eine Versprühung oder Tiefdruck einer entsprechenden Schichtfluidformulierung erfolgen, bei der die Beschichtung ggf. durch eine Maske auf einen bestimmten Bereich (Beschichtungsbereich) begrenzt wird.

In vielen Fällen wird das Schichtfluid unmittelbar auf die Oberfläche des Werkstücks aufgebracht, so dass die fertige Schutzschicht unmittelbar auf der Werkstückoberfläche haftet. Es ist jedoch auch möglich, dass vor dem Aufbringen des Schichtfluids eine Zwischenschicht auf die Oberfläche aufgebracht wird und dass danach das Schichtfluid auf die Zwischenschicht aufgebracht wird. Dadurch ist die Schutzschicht ein Teil eines mehrschichtigen, insbesondere zweischichtigen Schutzschichtsystems. Die Zwischenschicht kann z.B. als Haftvermittlungsschicht dienen. Alternativ oder zusätzlich kann das Material der Zwischenschicht auch so ausgewählt werden, dass eine möglichst rückstandsfreie Entfernung der Schutzschicht und der diese tragenden Zwischenschicht nach Abschluss der Laserbearbeitung möglich ist.

Mithilfe des Verfahrens kann die Qualität der Lasermikrobearbeitung durch Einsatz einer multifunktionalen Schutzschicht im Hinblick auf eines oder mehrere Ziele optimiert werden. Die Wirkung der Schutzschicht kann mindestens dreifach sein. Erstens kann durch eine nach der Bearbeitung rückstandslos entfernbare Schicht "debris" sehr wirksam von der Anhaftung im Bereich des Bearbeitungsortes abgehalten werden. Zweitens kann durch Aufbringen einer hinreichend dicken Schutzschicht die Kantenverrundung in die Schutzschicht hinein verlagert werden, so dass im Werkstück eine sehr gerade und "aufwerfungsfreie" Flanke entsteht. Drittens ist die Schutzschicht dem Wärmemanagement in der unmittelbaren Nähe der Laserbearbeitung zuträglich durch eine bessere Wärmeableitung. Damit können empfindliche, oberflächennahe Schichten des Werkstücks wirksam vor Schädigung durch die mit der Laserbearbeitung einhergehende Wärmeentwicklung in unmittelbarer Kantennähe bewahrt werden.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind.
- Fig. 1: zeigt einen Schnitt durch ein Werkstück in der Nähe einer Oberfläche, in der mittels Lasermikrobearbeitung ein Loch erzeugt werden soll, wobei auf die Oberfläche eine Schicht aus einem Partikel-haltigen Schichtfluid lokal begrenzt aufgebracht ist;
- Fig. 2: zeigt schematisch einen Trocknungsschritt zur Erzeugung einer getrockneten Schutzschicht aus der Schicht des Schichtfluids;
- Fig. 3: zeigt einen Bearbeitungsschritt, bei dem ein Laserstrahl durch die Schutzschicht hindurch auf das Werkstück eingestrahlt wird;
- Fig. 4: zeigt einen nasschemischen Reinigungsschritt zur Entfernung der Schutzschicht nach Abschluss der Laserbearbeitung;
- Fig. 5: zeigt eine rasterelektronenmikroskopische Aufnahme eines mit einer Schicht aus Leitsilber bedeckten Werkstücks nach Trocknung der Leitsilberschicht und Auskofferung mittels eines fokussierten Ga⁺-Ionenstrahls;
- Fig. 6: zeigt vier rasterelektronenmikroskopische Aufnahmen von nicht durch eine Schutzschicht geschützten Bereichen mit einer identischen Bearbeitungsstruktur nach Laserbearbeitung unter unterschiedlichen Umgebungsdruckbedingungen;
- Fig. 7: zeigt eine REM-Aufnahme einer mithilfe einer Leitsilber-Schutzschicht laserbearbeiteten, strukturierten Halbleiterprobe nach Entfernung der Schutzschicht und der damit entfernten Abtragsprodukte;
- Fig. 8: zeigt eine REM-Aufnahme eines FIB-Querschnitts quer zu einer laserbearbeiteten Flanke;
- Fig. 9: zeigt ein Ausführungsbeispiel, bei dem die Schutzschicht unter Zwischenschaltung einer partikelfreien Zwischenschicht auf das Werkstück aufgebracht wurde; und
- Fig. 10: zeigt die Entfernung einer Schutzschicht von der Werkstückoberfläche mittels eines CO₂-Strahls.

### DETAILLIERTE BESCHREIBUNG DER AUSFÜHRUNGSBEISPIELE

Nachfolgend werden Ausführungsbeispiele für Verfahren zur Herstellung eines mikrobearbeiteten Werkstücks mittels Laserabtrags (Laserablation) dargestellt. Bei den zu bearbeitenden Werkstücken kann es sich beispielsweise um Proben für die Mikrostrukturdiagnostik handeln, die unter Anwendung des Verfahrens mit hoher Qualität präpariert werden können. Das Verfahren kann auch bei der Laserbearbeitung von Displays oder bei der Bearbeitung von feinen Bohrungen, z.B. in Einspritzdüsen, genutzt werden. Bei dem Verfahren wird jeweils eine Schutzschicht unmittelbar oder mittelbar auf eine Oberfläche des Werkstücks aufgebracht und die Oberfläche wird in einem Bearbeitungsbereich durch die Schutzschicht hindurch mittels eines Laserstrahls bearbeitet.

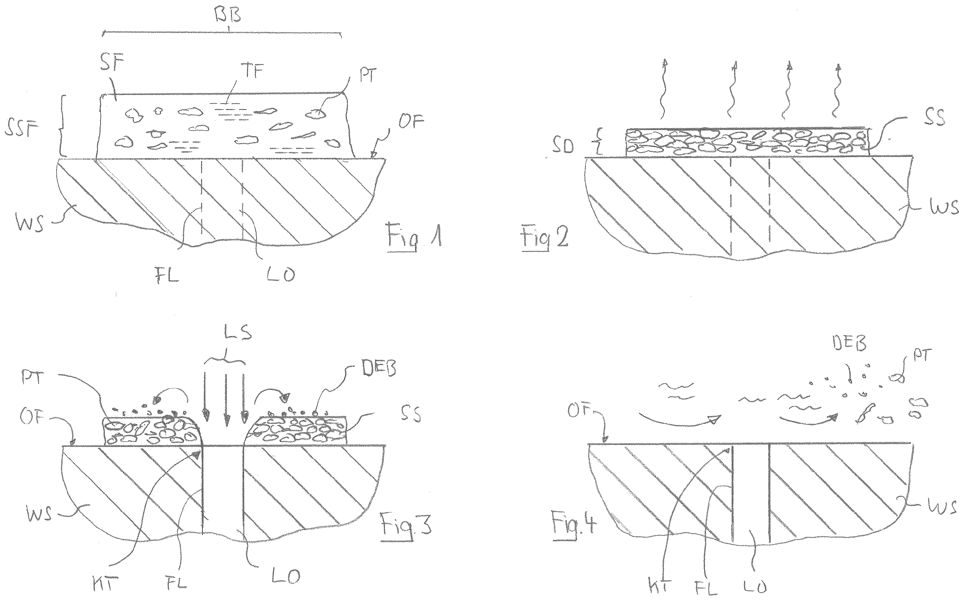

Anhand der Fig. 1 bis 4 werden zunächst einige wichtige Teilaspekte von Ausführungsbeispielen des Verfahrens erläutert. Fig. 1 zeigt schematisch einen Schnitt durch ein Werkstück WS in der Nähe derjenigen Oberfläche OF des Werkstücks, in die mithilfe materialabtragender Lasermikrobearbeitung ein scharfkantig begrenztes Loch LO mit im Winkel zur Werkstückoberfläche verlaufenden Flanken FL erzeugt werden soll. Das schematisch dargestellte Loch, das z.B. zumindest an der Oberfläche einen runden oder polygonalen Querschnitt haben kann, ist im noch unversehrten Werkstück mit gestrichelter Linie dargestellt. Die Flanken stehen in der Abbildung u.a. aus Darstellungsgründen senkrecht zur Oberfläche, meist stehen sie in schrägem Winkel dazu. Die Oberfläche OF des Werkstücks (auch Werkstückoberfläche genannt) ist im Bearbeitungsbereich BB um die Lochposition herum im Beispielsfall eben, sie kann jedoch auch mehr oder weniger stark strukturiert sein.

Bei dem Verfahren wird die zu erzeugende Schutzschicht unter Verwendung eines Schichtfluides SF erzeugt, das eine wenigstens teilweise flüchtige Trägerflüssigkeit TF aufweist, in der metallische und/oder keramische Partikel PT verteilt sind. Das Schichtfluid wird im Beispielsfall von Fig. 1 unmittelbar auf die Oberfläche OF des Werkstücks so aufgebracht, dass wenigstens der Bearbeitungsbereich um die gewünschte Position des Lochs mit einer Schicht SSF des Schichtfluids bedeckt ist. Im Beispielsfall wird das Schichtfluid lokal begrenzt so aufgebracht, dass nur der Bearbeitungsbereich um das Loch herum bedeckt ist, während außerhalb liegende Teile der Werkstückoberfläche unbeschichtet bleiben.

Nach dem Schritt des Aufbringens des Schichtfluids folgt ein Trocknungsschritt, der anhand von Fig. 2 schematisch erläutert wird. Während des Trocknungsschritts wird die aufgebrachte Schicht SSF aus Schichtfluid zur Reduzierung des Anteils an Trägerflüssigkeit derart getrocknet, dass sich aus dem Schichtfluid eine Schutzschicht SS bildet, die im Wesentlichen nur aus einem relativ dichten Verbund der Partikel PT des aufgebrachten Schichtfluids SF oder aber aus diesen Partikeln und einem gegenüber dem Schichtfluid deutlich reduzierten Anteil der Trägerflüssigkeit besteht.

Die Partikel können sich beim Aufbringen in einer mehrkomponentigen Trägerflüssigkeit befinden. Während die flüchtigen Komponenten der Trägerflüssigkeit verdunsten (gegebenenfalls befördert durch Erwärmung des beschichteten Bereichs, z.B. durch Tempern in einem Ofen, Infrarotbestrahlung, etc.) verbleiben nicht-flüchtige Komponenten der Trägerflüssigkeit zwischen den Partikeln zurück. Die nicht-flüchtigen Komponenten können einerseits den Kontakt zwischen den Partikeln wahren bzw. den Zusammenhalt der teilweise porösen Schutzschicht fördern, andererseits gewährleisten sie auch die Wiederablösbarkeit mit Verfahren, die an den verbleibenden Komponenten der Trägerflüssigkeit angreifen, z.B. um diese chemisch zu lösen.

Beim Verdampfen flüchtiger Bestandteile der Trägerflüssigkeit kommen die Partikel PT nach und nach in innigen Kontakt zueinander und bilden eine auf der Oberfläche OF relativ fest haftende Schutzschicht SS, deren effektive Schichtdicke SD deutlich geringer ist als die Schichtdicke des vorher aufgebrachten Schichtfluids. Während der Trocknungsphase nimmt der Feuchtegrad der Schicht immer weiter ab, gegebenenfalls bis zur vollständigen Durchtrocknung der Schutzschicht SS. Es können jedoch in der Schutzschicht auch schwer flüchtige oder nicht flüchtige Bestandteile der Trägerflüssigkeit verbleiben. Die Trocknung sollte vor Beginn der Laserbearbeitung jedenfalls so weit fortgeschritten sein, dass die mehr oder weniger trockene Schutzschicht auf der Werkstückoberfläche haften bleibt, auch wenn diese aus der Horizontalen gekippt wird.

Fig. 3 zeigt schematisch den Bearbeitungsschritt, bei dem der Bearbeitungsbereich mittels eines Laserstrahls LS bearbeitet wird, der durch die Schutzschicht SS hindurch auf das Werkstück einstrahlt und in dieses sukzessive tiefer eindringt, um das Loch LO zu erzeugen. Anhand von Fig. 3 können einige bei der Lasermikrobearbeitung entstehende Probleme anschaulich erläutert werden.

Ein wesentliches Problem ist die sogenannte Kantenschädigung bzw. Kantenverrundung, die maßgeblich von der Gauß-förmigen Intensitätsverteilung des Laserstrahls LS herrührt. Diese Intensitätsverteilung führt zu einer über den Strahlquerschnitt ungleichmäßigen Abtragscharakteristik und entsteht beim "Einlaufen" des Laserstrahls auf die Zielstelle praktisch zwangsläufig. Das Loch erweitert sich dadurch in der Nähe der Oberfläche, was in der Regel unerwünscht ist. In vielen praktischen Anwendungsfällen, vor allem im Bereich der IC-Technologie, also im Bereich der Laserbearbeitung von integrierten Halbleiterbauelementen, befinden sich die zu präparierenden Zielstellen nahe an der Werkstückoberfläche, weshalb die Verrundung der Kante bei der Laserbearbeitung häufig dadurch berücksichtigt wurde, dass größere Sicherheitsabstände relativ zur Zielstelle eingehalten wurden. Dies kann jedoch zum Beispiel längere Bearbeitungszeiten für eine abschließende Politur mittels fokussierten lonenstrahls (Focused Ion Beam, FIB) zur Folge haben, was die Effizienz eines kombinierten Laser-FIB-Prozesses signifikant reduzieren kann.

Wie in Fig. 3 gut zu erkennen ist, wird das Problem der Verrundung der mit Laser bearbeiteten Kante durch das Aufbringen der Schutzschicht grundsätzlich nicht gelöst. Die Verrundung wird aber in vertikaler Richtung in die Schutzschicht SS hinein verlagert, so dass sich an der Eintrittsseite des vom Laserstrahl erzeugten Lochs innerhalb der Schutzschicht SS eine Kantenverrundung ausbildet. Im besonders kritischen Kantenbereich KT am Übergang zwischen der Oberfläche OF des Werkstücks und der Flanke FL des Lochs entsteht jedoch ein scharfer, weitgehend ungeschädigter Übergang zwischen Werkstückoberfläche und ablatierter Kante bzw. Flanke.

Es ist unmittelbar erkennbar, dass die effektive Schichtdicke der Schutzschicht SS so gewählt werden sollte, dass der Bereich der Kantenverrundung ausschließlich innerhalb der Schutzschicht liegt, so dass die Werkstückkante sauber bleibt. Die Dicke der aufzubringenden Schutzschicht steht in einem definierten Verhältnis zum Strahlprofil, speziell zum Spotdurchmesser. Die zu erreichende effektive Schichtdicke der Schutzschicht kann wesentlich unter Berücksichtigung der Leistungsdichte und des Spot-Profils (M²-Wert) der eingesetzten Laserquelle bestimmt werden. Technisch ist diese gegebenenfalls durch die Art der Aufbringung oder durch die Größe der im Schichtsystem befindlichen Metallpartikel begrenzt. Die erforderliche effektive Schichtdicke der Schutzschicht wird maßgeblich beeinflusst vom Verhältnis der fluenzabhängigen, wellenlängenabhängigen und pulsabhängigen Ablationsschwellen von Substrat und Schutzschicht. Dies kann bei der Auslegung des Prozesses zur Herstellung der Schutzschicht berücksichtigt werden.

Ein zweites Problem ist das Anhaften von Abtragsprodukten ("debris") der Laserbearbeitung auf einer laserbearbeiteten Oberfläche. Das Anhaften von Abtragsprodukten DEB kann als Folge eines unzureichenden Abtransports von ablatiertem Werkstückmaterial während der Laserbearbeitung angesehen werden. Wenngleich in vielen Laser-Anlagen durch dedizierte Anblas- und Absaugsysteme eine Abführung von "debris" maschinenseitig begünstigt wird, so kann eine Kontamination der unmittelbaren Oberfläche des Werkstücks dennoch praktisch nicht völlig verhindert werden, da das Anhaften weniger auf Adhäsion als vielmehr auf dem "Anbacken" ablatierter Partikel beruht. Dies ist auch bei der Bearbeitung mittels längerer Ultrakurzpulslaser (Pulsdauer mehr als einige Pikosekunden) der Fall, da die abgetragenen Partikel bei ihrem Abtransport durch den Laser weiter bestrahlt werden und somit ein Nachheizeffekt einsetzt. Wie in Fig. 3 erkennbar, wird die Redeposition von Abtragsprodukten bzw. "debris" DEB auf der Oberfläche OF durch die Existenz der Schutzschicht SS verhindert, da sich die Abtragsprodukte in dem von der Schutzschicht geschützten Bearbeitungsbereich nicht auf der Werkstückoberfläche OF, sondern nur auf der Schutzschicht SS absetzen können und an dieser gebunden werden. Die Abtragsprodukte können dann anschließend gemeinsam mit der Schutzschicht SS vorzugsweise rückstandslos entfernt werden (vgl. Fig. 4).

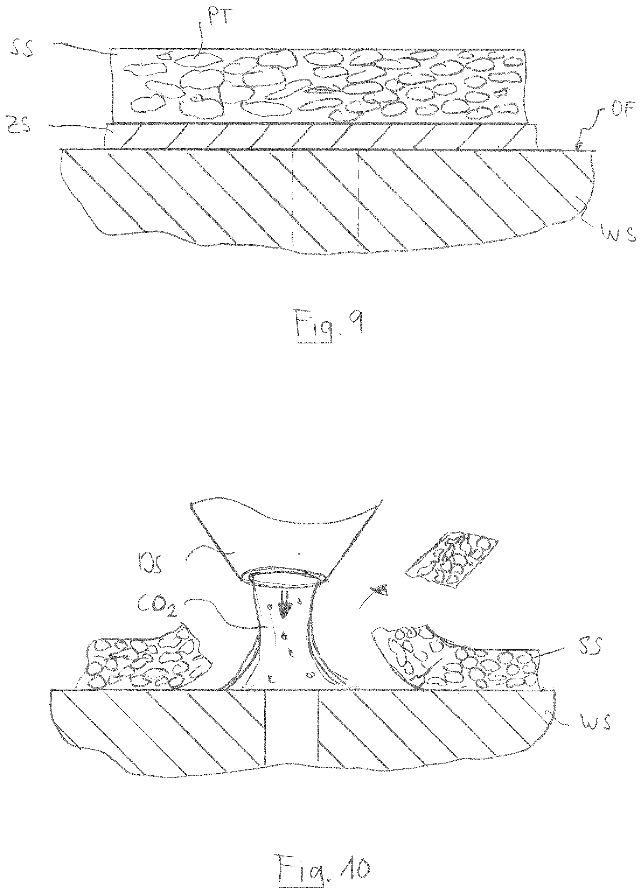

Wird ein thermisch schlecht leitendes Material, zum Beispiel Saphir, bearbeitet, so kann es bei der Laserbearbeitung zu einem lokalen Wärmestau und unkontrollierbaren, bisweilen weitreichenden Schädigungen in der Nähe der laserbearbeiteten Kanten kommen. Bei Vorhandensein einer gut wärmeleitenden, erfindungsgemäß metallischen Schutzschicht SS wird eine Abführung der Wärme in Lateralrichtung (also im Wesentlichen parallel zur Oberfläche) begünstigt, so dass durch Wärmestau verursachte Probleme reduziert werden können. Obwohl es in manchen Fällen möglich ist, dass die Schutzschicht mitsamt den darauf abgelagerten Abtragspartikeln auf dem Werkstück verbleibt, ist in der Regel eine idealerweise rückstandsfreie Ablösung der Schutzschicht und der Abtragsprodukte gewünscht. Fig. 4 zeigt schematisch eine Variante des Verfahrensschritts der Entfernung der Schutzschicht und der darauf abgelagerten Abtragsprodukte DEB mithilfe eines nasschemischen Lösungsmittels, welches lösliche Restbestandteile der Trägerflüssigkeit in der Schutzschicht anlöst, so dass sich der Zusammenhalt der Partikel PT der Schutzschicht auflöst und die Partikel PT sowie die Abtragsprodukte DEB rückstandsfrei von der Oberfläche OF weggespült werden können. Dieser Reinigungsprozess kann bei Bedarf durch Einwirkung von Ultraschall unterstützt werden. Alternativ kann das Ablösen der Schutzschicht z.B. auch durch eine CO₂-Schneestrahlreinigung erfolgen (vgl. Fig. 10).

Als besonders vielversprechend zur Lösung der genannten Probleme wird der Einsatz von rückstandslos entfernbaren, druckbaren Schutzlack-Systemen unter Verwendung von nanokolloidalen Metallpartikeln oder mikrometergroßen metallischen oder keramischen Plättchen (Flakes) angesehen. Infolge der guten elektrischen und Wärmeleitfähigkeit kommen zum Beispiel kommerziell verfügbare Metalltinten bzw. Metalllacke mit Partikeln aus Silber, Gold, Aluminium, Kupfer oder Nickel oder Kombinationen davon in Betracht, gegebenenfalls kombiniert mit entsprechend kleinen keramischen Partikeln.

Bei einem nachfolgend näher erläuterten Ausführungsbeispiel wurde ein kommerzieller silberhaltiger Leitlack ("Leitsilber") der Firma Ted Pella Inc. verwendet. Messungen haben ergeben, dass darin zirka 80 % der im Wesentlichen aus Silber bestehenden flockenartigen Partikel eine Größe von unter 1 µm haben. Dieses Schichtfluid hat eine flüchtige Trägerflüssigkeit auf Alkohol-Basis. Andere auf dem Markt existierende und als Schichtfluid geeignete Leitlacke verwenden eine Keton-Basis (zum Beispiel Methylisobutylketon) oder eine Azetat-Basis.

Für Anwendungen im Labormaßstab kann das Schichtfluid beispielsweise mittels Pinsel auf den interessierenden Arbeitsbereich aufgebracht werden. Für umfangreichere Stückzahlen und/oder eine Serienproduktion können solche Fluide auch mittels volumetrischer Methoden in einem Druckprozess auf die Werkstückoberfläche lokal begrenzt aufgebracht werden. Die getesteten Leitlacke auf Silberbasis können durch Einlegen in Azeton oder Alkohol rückstandsfrei von der Werkstückoberfläche entfernt werden, ggf. unterstützt durch Ultraschall.

Ein Vorteil der Verwendung von silberhaltigen Leitlacken liegt darin, dass Silber problemlos großtechnisch in brauchbaren Partikelgrößen (typischerweise kleiner 10 µm) hergestellt werden kann und dass Silber *per se* eine gute Wärmeleitfähigkeit aufweist. Es ist aber auch möglich, andere Metalle (zum Beispiel Aluminium oder Messing) in Kugelmühlen zu entsprechenden Flakes zu verarbeiten. Metallflakes, also plättchenartige Metallpartikel geringer Größe, finden auch verbreitet Einsatz als Substrate für Effektpigmente, welche in Lacken für Glitzern und Farbgebung sorgen. Derartige Flakes werden zur Farbbildung mit nanoskaligen Interferenzschichten überzogen. Schichtfluide mit derartigen Partikeln können ebenfalls verwendet werden.

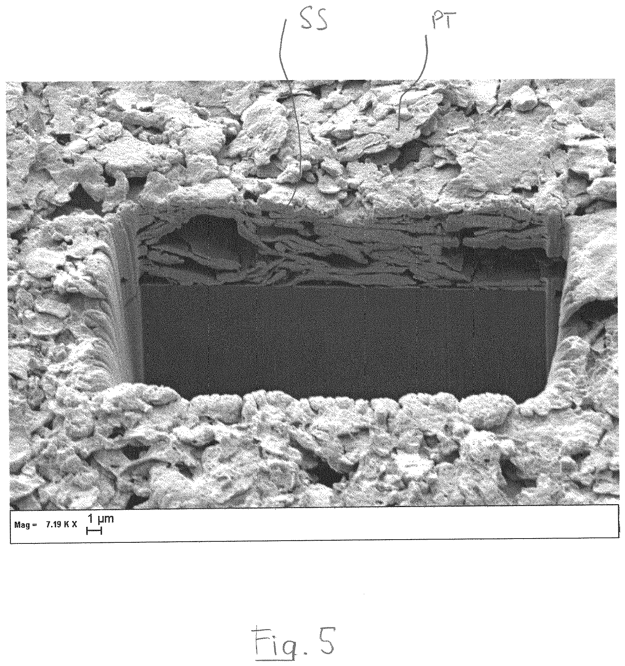

In einer Serie von Versuchen wurde Leitsilber auf einen zu bearbeitenden Bearbeitungsbereich mittels Pinsels in einer derartigen Dicke aufgebracht, dass die daraus resultierende Schutzschicht SS nach Verdampfen der flüchtigen Bestandteile der Trägerflüssigkeit eine effektive Schutzschichtdicke SD von ca. 4 bis 20 µm hatte. Fig. 5 zeigt eine rasterelektronenmikroskopische Aufnahme eines mit einer Schutzschicht aus Leitsilber bedeckten Werkstücks nach Trocknung der Leitsilberschicht. Zur besseren Veranschaulichung der inneren Struktur der Schutzschicht und des Übergangsbereich zum Werkstück wurde unter Nutzung eines fokussierten Gallium-Ionenstrahls eine rechteckige Auskofferung (Abtrag eines im Vergleich zum lonenstrahl großen Materialvolumens) erzeugt.

Es ist erkennbar, dass die Schutzschicht SS im Wesentlichen aus relativ kleinen, überwiegend plattenförmigen bzw. flockenförmigen Partikeln PT besteht, die innerhalb der Schicht in direktem Kontakt zueinander liegen, so dass die Schicht insgesamt durchgehend elektrisch und gut thermisch leitfähig ist. Die Schutzschicht hat aufgrund der Plättchenstruktur der Partikel eine schuppenartige Oberfläche. Zwischen den in Berührungskontakt stehenden Partikeln sind mikroskopisch kleine oder auch nanoskalige Poren zu erkennen. Die Poren haben sich beim Verdampfen der flüchtigen Bestandteile der Trägerflüssigkeit während des Trocknungsschritts gebildet. Der Füllgrad der Partikel innerhalb der Schutzschicht, also das Verhältnis zwischen dem Gesamtvolumen der Partikel in einem Einheitsvolumen der Schutzschicht und dem betrachteten Einheitsvolumen, liegt typischerweise bei ca. 60 % bis 80 %, so dass der Porenanteil etwa bei 20 bis 40 % liegt.

Diese dünne, überwiegend metallische Schutzschicht ist gekennzeichnet durch eine relativ hohe Abtragsschwelle bei Laserbearbeitung, wobei diese Abtragsschwelle ähnlich derjenigen des darunterliegenden massiven Materials des Werkstücks (Halbleitermaterial) liegen kann. Dadurch verhält sich die mikroporöse Schutzschicht hinsichtlich des Materialabtrags bei der Laserbearbeitung ähnlich wie das darunterliegende massive Werkstückmaterial und wird (im Gegensatz zu rein organischen Beschichtungen gleicher Dicke) insbesondere nicht sehr viel schneller abgetragen.

Im Bereich des Übergangs zwischen der Schutzschicht und dem darunterliegenden Werkstückmaterial verläuft die durch Laserbearbeitung freigelegte Flanke dagegen mehr oder weniger senkrecht zu der Werkstückoberfläche. Somit liegt nach Ablösen der Schutzschicht am Übergang zwischen den Flanken des Lochs und der Oberfläche ein scharfkantiger Übergang vor.

Die bei der Laserbearbeitung entstehenden Abtragsprodukte können sich aufgrund des Vorhandenseins der Schutzschicht während der Laserbearbeitung nicht auf der Oberfläche des Werkstücks absetzen, sondern allenfalls auf der rauen Oberfläche der Schutzschicht. Sie werden dann gemeinsam mit dieser entfernt.

Im Hinblick auf die Problematik der Ablagerung von "debris" auf der Werkstückoberfläche sollte die Schutzschicht zumindest denjenigen Bereich um die bearbeitete Stelle abdecken, welcher von den Abtragsprodukten bei der Laserbearbeitung erreicht werden kann. Die mittlere freie Weglänge bzw. die mittlere Flugweite der Partikel ist maßgeblich vom Umgebungsdruck abhängig. Bei Bearbeitung unter Vakuum können Partikulate auch einige zehn Zentimeter weit fliegen. Aus praktischen Erwägungen wird man jedoch eine Lasermikrobearbeitung unter Vakuumbedingungen meist vermeiden. Betrachtungen zur mittleren Flugweite können jedoch bei der Auslegung der richtigen Größe des durch die Schutzschicht zu bedeckenden Bereichs genutzt werden.

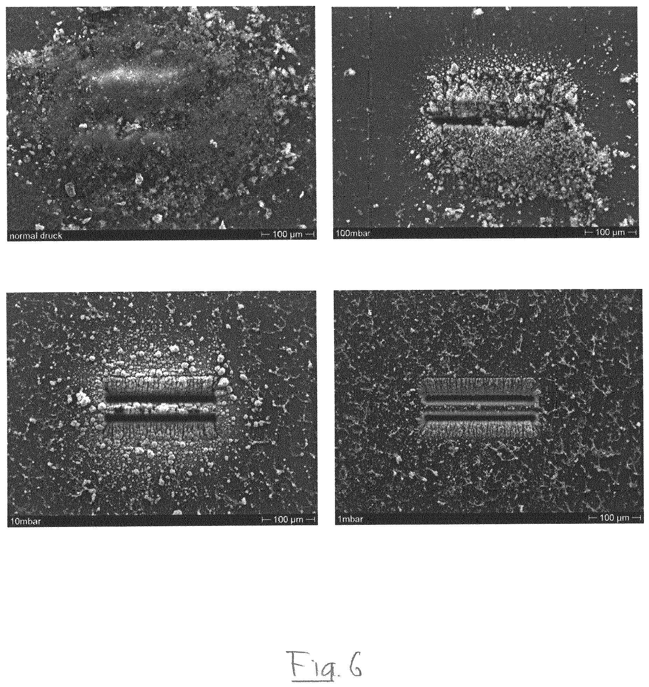

Als Beispiel dafür, dass die mittlere Flugweite bei ansonsten gleichen Bedingungen unter anderem vom Umgebungsdruck abhängt, zeigt Fig. 6 vier rasterelektronenmikroskopische Aufnahmen des Bereichs um eine Bearbeitungsstruktur nach Laserbearbeitung unter unterschiedlichen Umgebungsdruckbedingungen. Oben links ist die Situation nach Bearbeitung bei Normaldruck (ca. 1000 mbar) gezeigt. Es liegt eine große Dichte an Ablagerungspartikeln in einem relativ kleinen Bereich um die bearbeitete Struktur vor. Oben rechts ist eine vergleichbare Situation nach Bearbeitung bei 100 mbar gezeigt. Ein starker Einfluss auf die mittlere Flugweite ist hier noch nicht zu erkennen. Wie bei Normaldruck verteilen sich die Partikel überwiegend in einem Bereich von weniger als 1 mm um die Bearbeitungsstelle. Unten links ist die Situation nach einer Bearbeitung bei 10 mbar Umgebungsdruck gezeigt. Es findet sich eine relativ gleichmäßige Verteilung über einen vergleichsweisen großen Umgebungsbereich um die Bearbeitungsstelle, lediglich in unmittelbarer Nähe der Bearbeitungsstelle scheint die Dichte der Partikel etwas höher zu sein. Bei Bearbeitung bei starkem Unterdruck von 1 mbar (unten rechts) ergibt sich eine noch gleichmäßigere Verteilung der Abtragsprodukte über eine noch größere Fläche bzw. einen noch größeren Radius.

Aus derartigen Versuchen kann abgeschätzt werden, wie durch Einstellung des Umgebungsdrucks die räumliche Verteilung von Abtragsprodukten um die Bearbeitungsstelle beeinflusst werden kann. Gegebenenfalls kann z.B. bei Überdruck gearbeitet werden, um die Flugweite zu reduzieren. Der Bearbeitungsprozess kann beispielsweise so geführt werden, dass ein Umgebungsdruck eingestellt wird, welcher dazu führt, dass die Debrispartikel überwiegend maximal 2 bis 5 mm von der Bearbeitungsstelle entfernt landen können. Entsprechend groß kann bei einer lokalen Beschichtung um die Bearbeitungsstelle die Größe des beschichteten Bereichs gewählt werden. Bereiche, die deutlich außerhalb der mittleren Flugweite liegen, können unbeschichtet bleiben.

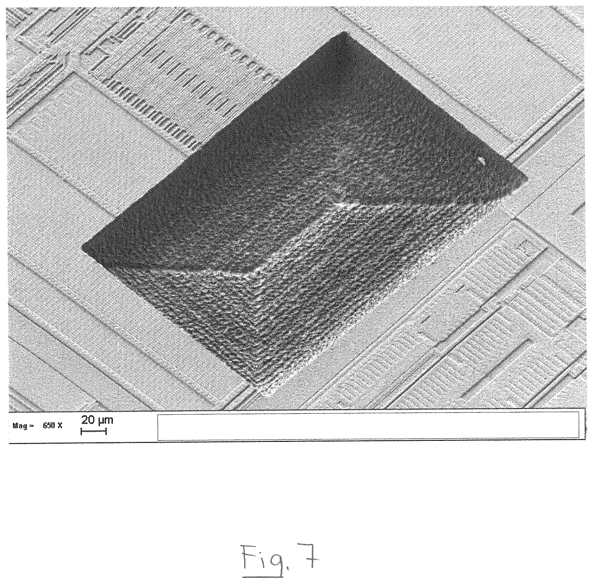

Ein großer Vorteil von Verfahren gemäß Ausführungsbeispielen der beanspruchten Erfindung liegt darin, dass mithilfe des Schutzschicht-bildenden Schichtfluids nicht nur ebene Oberflächen zuverlässig geschützt werden können, sondern auch unebene Werkstückoberflächen, d.h. Werkstückoberflächen mit einer strukturierten Oberfläche, wie sie beispielsweise bei funktionalen Halbleiterbauelementen vorkommen. Auch an derartige Strukturen kann sich die Schutzschicht formschlüssig und topographiekonform anpassen. Zur Veranschaulichung zeigt Fig. 7 eine REM-Aufnahme einer mithilfe einer Leitsilber-Schutzschicht laserbearbeiteten, strukturierten Halbleiterprobe nach Entfernung der Schutzschicht und der damit entfernten Abtragsprodukte. Es ist erkennbar, dass die nach Entfernung der Schutzschicht wieder freiliegende Oberfläche OF des Werkstücks Strukturen in Form zueinander paralleler Wülste bzw. Linien aufweist.

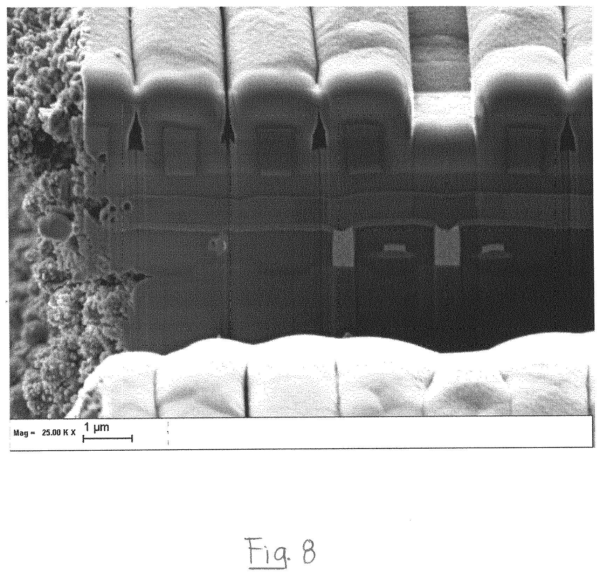

In der vergrößerten Detailansicht in Fig. 8 ist zu erkennen, dass auf der strukturierten Werkstückoberfläche keinerlei Bearbeitungsrückstände mehr vorhanden sind und dass eine eventuell durch Laserstrahlung beeinflusste Zone im Werkstück nur geringe Ausdehnung hat.

Es ist erkennbar, dass die Metall-Plättchen enthaltende Schutzschicht nach Aufbringung und Lasermikrobearbeitung rückstandslos entfernt werden kann. Weiterhin ist erkennbar, dass die Metallpartikelschicht aufgrund des guten Kontakts und der hohen Wärmeleitfähigkeit eine wichtige Rolle im Wärmemanagement der bearbeiteten Position übernehmen kann. Beispielsweise kann es sein, dass bei Bearbeitung mit einem Pikosekundenlaser die Wärmeeinflusszone selbst in einem vergleichsweise dicken Heterosystem typischerweise nicht größer als 2 µm ist. Weiterhin ist erkennbar, dass nach Ablösen der Metallpartikelschicht (Schutzschicht) keinerlei "debris" auf der Oberfläche neben der Bearbeitungsflanke anzutreffen ist. Weiterhin ist kein Aufwurf an der Schnittkante zu erkennen.

Es kann Situationen geben, in denen es schwierig ist, mehreren Anforderungen an die Optimierung gleichzeitig in ausreichendem Maße gerecht zu werden, beispielsweise hinsichtlich Vermeidung von Kantenverrundung, Vermeidung von Ablagerungen auf der freien Werkstückoberfläche und Wärmemanagement. Gegebenenfalls muss ein Kompromiss gesucht werden zwischen einer möglichst dichten Packung der Metallpartikel in der Schutzschicht (unter anderem für maximale thermische Leitfähigkeit) einerseits und einer möglichst großen Porosität der Schicht für eine gute Lösbarkeit der nicht-metallischen Bestandteile, wie zum Beispiel Binder, Stabilisatoren etc., andererseits. Im Hinblick auf diese widerstrebenden Forderungen kann es sinnvoll sein, gemäß einer Verfahrensvariante vorzugehen, bei der das Schichtfluid nicht direkt auf die zu schützende Werkstückoberfläche aufgebracht wird, sondern unter Zwischenschaltung einer Zwischenschicht, welche auf die Werkstückoberfläche aufgebracht wird, bevor das Schichtfluid dann auf die freie Oberfläche der Zwischenschicht aufgebracht wird.

Fig. 9 zeigt hierzu schematisch einen Schnitt durch eine Werkstückoberfläche, auf die zunächst eine ggf. partikelfreie Zwischenschicht ZS und anschließend auf diese Zwischenschicht die eigentliche Partikel-haltige Schutzschicht SS aufgebracht wurde. Das Material für die Zwischenschicht ZS kann beispielsweise so gewählt werden, dass eine nasschemische oder CO₂-Strahl-basierte Ablösung des gesamten Schutzschichtsystems (Schutzschicht SS plus Zwischenschicht ZS) leicht möglich ist. Im Gegensatz zu einer direkten Aufbringung der Schutzschicht auf die Oberfläche des Werkstücks wird also hier die Partikel-haltige Schutzschicht SS auf einem seinerseits ablösbaren Film, nämlich der Zwischenschicht, deponiert. Hierdurch entfällt die Notwendigkeit der Auflösbarkeit für die eigentliche Partikelschicht (Schutzschicht), die gegebenenfalls gemeinsam mit der darauf abgelagerten "debris" flächig (als Ganzes zusammenhängend) beim Ablösen der Zwischenschicht entfernt wird. Die Zwischenschicht ist dabei durch die Partikel-haltige Schutzschicht SS vor direkter Laserexposition geschützt. Unter anderem deshalb ist es auch nicht nötig, dass die Zwischenschicht ZS Metallpartikel und/oder Keramikpartikel (z.B. aus TiO₂) enthält. Dies kann jedoch vorgesehen sein.

Für Varianten mit Einzelschichten, also mit einer Schutzschicht, die direkt auf die Oberfläche des Werkstücks aufgebracht wird, lassen sich unter anderem folgende Anforderungen festhalten: die Schutzschicht sollte eine ausreichend hohe Ablationsschwelle bei der Laserbearbeitung haben und in ausreichender Dicke applizierbar sein. Vorzugsweise sollten eine gute Lösbarkeit von der Oberfläche und eine hohe thermische Leitfähigkeit vorliegen. Die Schutzschicht kann infolge ihres Gefüges thermomechanische Spannungen gegebenenfalls in gewissen Grenzen kompensieren.

Bei Varianten, die eine Zwischenschicht zwischen Schutzschicht und Werkstückoberfläche nutzen, sollte darauf geachtet werden, dass keine Veraschung des Zwischenschichtmaterials durch Lasereinkopplung verursacht wird und dass das Zwischenschichtmaterial in ausreichender Dicke applizierbar ist. Die Zwischenschicht kann partikelfrei sein oder gegebenenfalls mit Keramikpartikeln versetzt sein, um eine thermische Entkopplung der Werkstückoberfläche von einer Metallpartikel enthaltenden Schutzschicht zu begünstigen. Die Zwischenschicht kann auch als thermomechanische Anpassungsschicht fungieren, um induzierte thermomechanische Spannungen zwischen Werkstück und Schutzschicht zu kompensieren.

Es gibt unterschiedliche Möglichkeiten, die Schutzschicht bzw. ein Schutzschichtsystem mit einer Kombination aus Schutzschicht und Zwischenschicht auf das Werkstück aufzubringen. Die Technologie, mit deren Hilfe die Schutzschicht/das Schutzschichtsystem reproduzierbar aufgebracht werden kann, hängt nicht nur von der Formulierung des Schichtfluids, sondern auch vom konkreten Anwendungsfall ab.

Im Falle eines Einsatzes im Bereich der Vereinzelungstechnologie (zum Beispiel IC-Vereinzelung, Display-Konfektionierung etc.) erscheint es meist sinnvoll, die Schutzschicht vollflächig unstrukturiert auf die gesamte zu vereinzelnde Struktur (zum Beispiel einen Halbleiterwafer) aufzubringen. Hierfür können sich beispielsweise Siebdruckverfahren, Rakeln, Hochdruck-Verdüsung, Spin-Coating, Dip-Coating, Tampondruck oder dergleichen eignen.

Soll die Schutzschicht definiert lokal begrenzt aufgebracht werden, so dass auch unbeschichtete Bereiche verbleiben, erscheinen hier vor allem volumetrische Methoden unter Verwendung von Dosierventilen (beispielsweise Jet-Valve, Kolben- und Spindelventile) oder aber Sprühventile besonders geeignet. Ebenso können mittels Continuous-Inkjet (Drop-on-Demand) einzelne Tropfen zielgerichtet mittels elektrostatischer Ablenker auf die Zielstelle appliziert werden. Alternativ kann eine Versprühung oder Tiefdruck einer entsprechenden Schichtfluidformulierung erfolgen, bei der die Beschichtung gegebenenfalls durch eine Maske auf einen bestimmten Bereich begrenzt wird. Die lokal begrenzte Applikation von Schichtfluid kann beispielsweise im Rahmen von Prozesserprobungen oder bei der Probenpräparation von Proben für die Mikrostrukturdiagnostik von Vorteil sein.

In den meisten Anwendungsfällen sollte die Schutzschicht nach der Laserbearbeitung wieder rückstandslos vom Werkstück entfernt werden. Hierfür scheinen insbesondere zwei Vorgehensweisen geeignet. Sofern in einer Partikel-basierten Schutzschicht Binder und Stabilisatoren bzw. Bestandteile der Trägerflüssigkeit mit einer gewissen chemischen Löslichkeit vorliegen, so kann die Schutzschicht großflächig durch Umspülen mit einem geeigneten Lösungsmittel entfernt werden (vgl. Fig. 4). Dieser Prozess kann unter Umständen mechanisch (zum Beispiel durch Bürsten mit Pinsel) oder durch Ultraschall unterstützt werden.

Alternativ kann die Schutzschicht oder das Schutzschichtsystem mithilfe eines CO₂-Snowjet lokal von der Oberfläche entfernt werden (vgl. Fig. 10). Hierbei wird (flüssiges) CO₂ beim Austritt aus einer Düse DS entspannt, mittels Druckluft auf Überschallgeschwindigkeit beschleunigt und auf das mit Schutzschicht SS versehene Werkstück WS geleitet. Beim Auftreffen auf die Schutzschicht kühlt sich diese schnell ab und versprödet. Da der CO₂-Schnee beim Auftreffen auf die Oberfläche mit einer Volumenzunahme abdampft, werden Partikelbelegungen üblicherweise nahezu rückstandsfrei von der Oberfläche des Werkstücks gesprengt. Dieser Umstand wird zusätzlich dadurch begünstigt, dass CO₂ ein starkes Lösungsmittel für organische Verbindungen ist, wie sie in der Schichtformulierung als Binder oder Stabilisatoren enthalten sein können. Erfolgreiche Versuche wurden mit einem System zur CO₂-Schneestrahlreinigung der Firma acp - advanced clean production GmbH, Ditzingen, Deutschland durchgeführt.

Technisch kann eine Einrichtung zur Schichtaufbringung (also ein Beschichtungssystem zur Erzeugung einer Schutzschicht auf dem Werkstück) zum Beispiel mit Continuous-Inkjet oder Dosierventilen in einer Lasermikrobearbeitungsanlage mit Werkstückbewegungssystem implementiert werden. Solche Anlagen können neben einer Laserbearbeitungsposition noch eine Beobachtungsposition aufweisen, wobei vorzugsweise zwischen den Positionen unter Kenntnis des Offsets mit hoher Präzision, beispielsweise mit weniger als 1 bis 2 µm Wiederholgenauigkeit, hin- und hergewechselt werden kann. Zusätzlich kann dann noch eine Beschichtungsposition, insbesondere in Form einer Bedruckposition, vorgesehen sein, in der mit der gleichen Präzision die Applizierung des Schichtfluids zur Erzeugung der Schutzschicht erfolgen kann. Durch mehrfaches Bedrucken und/oder Wahl größerer Tröpfchen können bei Bedarf dickere Schichten erzeugt werden.

Für den Grenzfall großflächiger Beschichtungen kann es sinnvoll sein, die Werkstücke (zum Beispiel Wafer) zunächst in einer gesonderten speziellen Anlage zu beschichten und anschließend losweise oder kontinuierlich in die Laserbearbeitungsanlage zu überführen. Auch das Entfernen der Schutzschicht wird vorzugsweise in einer separaten Anlage bzw. in einem separaten Prozessschritt erfolgen.

Die Erfindung ermöglicht eine signifikante Qualitätssteigerung bei der laserbasierten Fertigung präziser Bauteile, beispielsweise Bohrungen in Einspritzdüsen oder Displays oder eine Fertigung von Proben für die Mikrostrukturdiagnostik. Mithilfe der Erfindung können Einlaufverhalten, Eintrittsgeometrie, Kontamination mit Abtragsprodukten und thermische Belastung der bearbeiteten Werkstücke im Vergleich zum Stand der Technik verbessert werden.

## Patentansprüche

1. Verfahren zur Herstellung eines mikrobearbeiteten Werkstücks mittels Lasermikrobearbeitung, worin eine Schutzschicht (SS) auf eine Oberfläche (OF) des Werkstücks (WS) aufgebracht wird und die Oberfläche in einem Bearbeitungsbereich durch die Schutzschicht hindurch mittels eines Laserstrahls (LS) bearbeitet wird, **dadurch gekennzeichnet, dass**
die Schutzschicht (SS) unter Verwendung eines Schichtfluids (SF) erzeugt wird, das eine wenigstens teilweise flüchtige Trägerflüssigkeit (TF) aufweist, in der metallische Partikel (PT) verteilt sind;
das Schichtfluid (SF) auf die Oberfläche (OF) so aufgebracht wird, dass wenigstens der Bearbeitungsbereich (BB) mit einer Schicht (SSF) des Schichtfluids bedeckt ist;
die aufgebrachte Schicht zur Reduzierung des Anteils an Trägerflüssigkeit (TF) derart getrocknet wird, dass sich eine Schutzschicht (SS) bildet, die im Wesentlichen aus den Partikeln (PT) des aufgebrachten Schichtfluids oder aus diesen Partikeln und einem gegenüber dem Schichtfluid reduzierten Anteil der Trägerflüssigkeit besteht; und
der Bearbeitungsbereich mittels eines Laserstrahls (LS) bearbeitet wird, der durch die Schutzschicht hindurch auf das Werkstück (WS) eingestrahlt wird, wobei die Schutzschicht (SS) die Wärmeableitung in der unmittelbaren Nähe der Laserbearbeitung verbessert.

2. Verfahren nach Anspruch 1, **dadurch gekennzeichnet, dass**
ein Schichtfluid verwendet wird, bei dem die Partikel überwiegend eine Partikelgröße von maximal 10 µm aufweisen.

3. Verfahren nach Anspruch 1 oder 2, **dadurch gekennzeichnet, dass** die Zusammensetzung des Schichtfluids (SF) derart gewählt wird, dass ein Füllgrad der Partikel (PT) in der fertigen Schutzschicht (SS) bei über 50% des Schutzschichtvolumens liegt, wobei der Füllgrad vorzugsweise mehr als 60% beträgt.

4. Verfahren nach einem der vorhergehenden Ansprüche, **dadurch gekennzeichnet, dass** das Schichtfluid (SF) überwiegend oder ausschließlich metallische Partikel (PT) mit einer Beschichtung oder ohne Beschichtung enthält.

5. Verfahren nach einem der vorhergehenden Ansprüche, **dadurch gekennzeichnet, dass** ein Leitlack, insbesondere Leitsilber, als Schichtfluid (SF) verwendet wird.

6. Verfahren nach einem der vorhergehenden Ansprüche, **dadurch gekennzeichnet, dass** die Schutzschicht mit einer effektiven Schutzschichtdicke (SD) von weniger als 50 µm erzeugt wird.

7. Verfahren nach einem der vorhergehenden Ansprüche, **dadurch gekennzeichnet, dass** die Schutzschicht (SS) nach Abschluss der Laserbearbeitung von der Oberfläche (OF) entfernt wird.

8. Verfahren nach Anspruch 7, **dadurch gekennzeichnet, dass**
zum Entfernen der Schutzschicht (SS) ein Lösungsmittel verwendet wird, das in der Schutzschicht verbliebene nicht oder schwer flüchtige Bestandteile der Trägerflüssigkeit löst, oder dass zum Entfernen der Schutzschicht (SS) ein auf die Schutzschicht gerichteter CO₂-Strahl verwendet wird.

9. Verfahren nach einem der vorhergehenden Ansprüche, **dadurch gekennzeichnet, dass** die Laserbearbeitung während einer Trocknungsphase der Schicht innerhalb eines Zeitfensters durchgeführt wird, in welchem die Schutzschicht (SS) noch einen Anteil an Trägerflüssigkeit enthält.

10. Verfahren nach einem der vorhergehenden Ansprüche, **dadurch gekennzeichnet, dass** beim Aufbringen der Schichtfluids (SF) das Schichtfluid lokal begrenzt in einem den Bearbeitungsbereich (BB) enthaltenden Beschichtungsbereich auf die Oberfläche (OF) aufgebracht wird, wobei außerhalb eines Beschichtungsbereichs die Oberfläche (OF) unbeschichtet bleibt.

11. Verfahren nach Anspruch 10, **dadurch gekennzeichnet, dass**
durch Einstellung des Umgebungsdrucks die räumliche Verteilung von Abtragsprodukten um die Bearbeitungsstelle beeinflusst wird, wobei vorzugsweise ein Umgebungsdruck eingestellt wird, welcher dazu führt, dass die Abtragsprodukte überwiegend maximal 2 bis 5 mm von der Bearbeitungsstelle entfernt landen.

12. Verfahren nach einem der vorhergehenden Ansprüche, **dadurch gekennzeichnet, dass** beim Aufbringen der Schutzschicht (SS) das Schichtfluid mittels eines volumetrischen Verfahrens aufgebracht wird.

13. Verfahren nach einem der vorhergehenden Ansprüche, **dadurch gekennzeichnet, dass** vor dem Aufbringen des Schichtfluids (SF) eine Zwischenschicht (ZS) auf die Oberfläche (OF) aufgebracht wird und dass danach das Schichtfluid auf die Zwischenschicht aufgebracht wird.

14. Verwendung eines metallische Partikel aufweisenden Leitlacks, insbesondere Leitsilber, als Schichtfluid zur Erzeugung einer Schutzschicht bei der Durchführung des Verfahrens nach einem der vorhergehenden Ansprüche.

## Claims

1. Method for the production of a micromachined workpiece by means of laser micromachining, wherein a protective layer (SS) is applied to a surface (OF) of the workpiece (WS) and the surface is machined in a machining area by means of a laser beam (LS) through the protective layer,
**characterized in that**
the protective layer (SS) is generated using a coating fluid (SF) that contains an at least partially volatile carrier liquid (TF) in which metallic particles (PT) are dispersed;
the coating fluid (SF) is applied to the surface (OF) such that at least the machining area (BB) is covered with a layer (SSF) of the coating fluid;
the applied layer is dried in order to reduce the proportion of carrier liquid (TF) in such a manner that a protective layer (SS) forms, which is essentially composed of the particles (PT) of the applied coating fluid or of these particles and a reduced proportion of the carrier liquid relative to the coating fluid; and
machining of the machining area is carried out by means of a laser beam (LS), which is irradiated through the protective layer onto the workpiece (WS), wherein the protective layer (SS) improves heat dissipation in the immediate vicinity of the laser machining.

2. Method according to claim 1, **characterized in that** a coating fluid is used in which the particles predominantly have a maximum particle size of 10 µm.

3. Method according to claim 1 or 2, **characterized in that** the composition of the coating fluid (SF) is selected such that a filling ratio of the particles (PT) in the finished protective layer (SS) is over 50% of the protective layer volume, wherein the filling ratio is preferably more than 60%.

4. Method according to any of the preceding claims, **characterized in that** the coating fluid (SF) predominantly or exclusively contains metallic particles (PT) with a coating or without a coating.

5. Method according to any of the preceding claims, **characterized in that** a conductive lacquer, more particularly conductive silver, is used as a coating fluid (SF).

6. Method according to any of the preceding claims, **characterized in that** the protective layer is generated with an effective protective layer thickness (SD) of less than 50 µm.

7. Method according to any of the preceding claims, **characterized in that** the protective layer (SS) is removed from the surface (OF) after completion of the laser machining.

8. Method according to claim 7, **characterized in that**, in order to remove the protective layer (SS), a solvent is used that dissolves non-volatile or sparingly-volatile components of the carrier liquid remaining in the protective layer, or **in that**, in order to remove the protective layer (SS), a CO₂ beam directed onto the protective layer is used.

9. Method according to any of the preceding claims, **characterized in that** the laser machining is carried out during a drying phase of the layer within a time frame in which the protective layer (SS) still contains an amount of carrier liquid.

10. Method according to any of the preceding claims, **characterized in that** during application of the coating fluid (SF), the coating fluid is applied to the surface (OF) in a locally restricted manner on a coating area containing the machining area (BB), wherein the surface (OF) remains uncoated beyond a coating area.

11. Method according to claim 10, **characterized in that** by adjusting the ambient pressure, the spatial distribution of ablation products around the machining site is affected, wherein preferably an ambient pressure is set which causes the ablation products to land predominantly at a maximum distance of 2 to 5 mm from the machining site.

12. Method according to any of the preceding claims, **characterized in that** during application of the protective layer (SS), the coating fluid is applied by means of a volumetric method.

13. Method according to any of the preceding claims, **characterized in that**, before application of the coating fluid (SF), an intermediate layer (ZS) is applied to the surface (OF) and **in that** subsequently the coating fluid is applied to the intermediate layer.

14. Use of a conductive lacquer including metallic particles, more particularly conductive silver, as a coating fluid to generate a protective layer during performing the method according to any of the preceding claims.

## Revendications

1. Procédé de fabrication d'une pièce micro-usinée par micro-usinage laser, procédé dans lequel une couche de protection (SS) est appliquée sur une surface (OF) de la pièce (WS) et la surface est usinée dans une zone d'usinage à travers la couche de protection au moyen d'un faisceau laser (LS),
**caractérisé en ce que**
la couche de protection (SS) est produite à l'aide d'un fluide de couche (SF) qui comporte un liquide porteur (TF) au moins partiellement volatil dans lequel des particules métalliques (PT) sont distribuées ;
le fluide de couche (SF) est appliqué sur la surface (OF) de telle manière qu'au moins la zone d'usinage (BB) soit recouverte d'une couche (SSF) du fluide de couche ;
la couche appliquée est séchée pour réduire la proportion de liquide porteur (TF) de telle manière qu'une couche de protection (SS) est formée qui comprend sensiblement des particules (PT) du fluide de couche appliqué ou lesdites particules et une proportion du liquide porteur qui est réduite par rapport au fluide de couche ; et
la zone d'usinage est usinée au moyen d'un faisceau laser (LS) qui est émis à travers la couche de protection de manière incidente à la pièce (WS), la couche de protection (SS) améliorant la dissipation thermique au voisinage immédiat de l'usinage au laser.

2. Procédé selon la revendication 1, **caractérisé en ce qu'**un fluide de couche est utilisé dans lequel les particules ont majoritairement une granulométrie d'au plus 10 µm.

3. Procédé selon la revendication 1 ou 2, **caractérisé en ce que**
la composition du fluide de couche (SF) est choisie de telle sorte qu'un taux de remplissage des particules (PT) dans la couche de protection finie (SS) soit supérieur à 50 % du volume de la couche de protection, le taux de remplissage étant de préférence supérieur à 60 %.

4. Procédé selon l'une des revendications précédentes, **caractérisé en ce que**
le fluide de couche (SF) contient majoritairement ou exclusivement des particules métalliques (PT) pourvues ou dépourvues d'un revêtement.

5. Procédé selon l'une des revendications précédentes, **caractérisé en ce qu'**une peinture conductrice, notamment de l'argent conducteur, est utilisée comme fluide de couche (SF).

6. Procédé selon l'une des revendications précédentes, **caractérisé en ce que** la couche de protection est réalisée avec une épaisseur de couche de protection effective (SD) inférieure à 50 µm.

7. Procédé selon l'une des revendications précédentes, **caractérisé en ce que** la couche de protection (SS) est retirée de la surface (OF) après achèvement de l'usinage au laser.

8. Procédé selon la revendication 7, **caractérisé en ce qu'**un solvant est utilisé pour éliminer la couche de protection (SS), lequel solvant dissout les constituants non volatils ou peu volatils du liquide porteur qui sont restés dans la couche de protection, ou **en ce qu'**un jet de CO₂ dirigé sur la couche de protection est utilisé pour éliminer la couche de protection (SS).

9. Procédé selon l'une des revendications précédentes, **caractérisé en ce que** l'usinage au laser est réalisé lors d'une phase de séchage de la couche dans une fenêtre temporelle dans laquelle la couche de protection (SS) contient encore une proportion de liquide porteur.

10. Procédé selon l'une des revendications précédentes, **caractérisé en ce que**
lors de l'application des fluides de couche (SF), le fluide de couche est appliqué de manière localement limitée à la surface (OF) dans une zone de revêtement contenant la zone d'usinage (BB), la surface (OF) restant sans revêtement à l'extérieur d'une zone de revêtement.

11. Procédé selon la revendication 10, **caractérisé en ce que**
la distribution spatiale des produits d'enlèvement autour du point d'usinage est influencée par réglage de la pression ambiante, une pression ambiante étant de préférence réglée afin que les produits d'enlèvement se retrouvent principalement à une distance maximale de 2 à 5 mm du point d'usinage.

12. Procédé selon l'une des revendications précédentes, **caractérisé en ce que**, lors de l'application de la couche de protection (SS), le fluide de couche est appliqué au moyen d'un procédé volumétrique.

13. Procédé selon l'une des revendications précédentes, **caractérisé en ce qu'**une couche intermédiaire (ZS) est appliquée sur la surface (OF) avant l'application du fluide de couche (SF) et **en ce que** le fluide de couche est ensuite appliqué sur la couche intermédiaire.

14. Utilisation d'une peinture conductrice contenant des particules métalliques, en particulier de l'argent conducteur, comme fluide de couche pour produire une couche de protection lors de la mise en œuvre du procédé selon l'une des revendications précédentes.
